# EUROPEAN PATENT APPLICATION

(11) **EP 2 133 747 A1**
(43) Date of publication of application: **16.12.2009**
(21) Application number: 08711659.6
(22) Date of filing: 20.02.2008
(51) Int. Cl.: G03F 7/40, H01L 21/027

(54) **RESIN COMPOSITION FOR MICROPATTERN FORMATION AND METHOD OF MICROPATTERN FORMATION**

(30) Priority: 26.02.2007 JP 2007046245
(71) Applicant: JSR Corporation, Tokyo 104-8410 (JP)
(72) Inventor: NAGAI, Tomoki, Tokyo 104-8410 (JP); NAKAMURA, Atsushi, Tokyo 104-8410 (JP); ABE, Takayoshi, Tokyo 104-8410 (JP); SUGIURA, Makoto, Tokyo 104-8410 (JP)
(74) Representative: TBK-Patent
(86) International application number: PCT/JP2008/052853
(87) International publication number: WO 2008/105293

(57) **Abstract**

A resin composition which can increase the pattern shrink rate while maintaining the advantages of capability of effectually and precisely micronizing the resist pattern gaps irrespective of the surface conditions of the substrate and forming resist patterns exceeding the wavelength limit economically at low cost in a good condition having only small defects, and a method of efficiently forming a micropattern using the resin composition are disclosed. The resin composition for forming a micropattern includes a hydroxyl group-containing resin, a crosslinking component, and an alcohol solvent which contains an alcohol and not more than 10 mass% of water relative to the total solvent. The crosslinking component includes a compound having two or more acryloyloxy groups in the molecule.

## Description

### TECHNICAL FIELD

The present invention relates to microfabrication technology using a photoresist, particularly to a resin composition for forming a micropattern used when shrinking a pattern by heat treatment after patterning, and a method of forming a micropattern. More particularly, the present invention relates to a resin composition for forming a micropattern which can increase the pattern shrink rate, and a method of forming a micropattern.

### BACKGROUND ART

Along with the progress of micronization of semiconductor devices, further micronization of a lithography process used when manufacturing semiconductor devices has been demanded. Specifically, microfabrication with a line width of 100 nm or less is required in the lithography process, and various methods for forming a micropattern using a photoresist material which can be used with short-wavelength radiation such as ArF excimer laser light and an F₂ excimer laser light have been investigated.

Micronization using such a lithography technology has a limit due to the wavelength limit of radiation. Therefore, researches for forming a micropattern exceeding the wavelength limit have been conducted. Methods that have been heretofore proposed for micronizing a pattern include, for example, a method of preparing a resist pattern from a resist for use with electron beams such as polymethyl methacrylate, applying a positive-tone resist onto the resist pattern, producing a reaction layer in the boundary of the resist pattern and the positive-tone resist layer by a heat treatment, and removing the unreacted regions on the positive-tone resist (Patent Document 1), a method of forming a reactive layer between the lower layer resist pattern and the upper layer resist utilizing thermal crosslinking induced by an acid generator or an acid (Patent Document 2), a method of manufacturing a semiconductor device using a micropattern forming material which does not contain a photosensitive component but contains a water-soluble resin, a water-soluble crosslinking agent, or a mixture of these dissolved in an aqueous solvent, as an upper layer resist coating solution (Patent Document 3), and a method of providing a photosensitive layer of a chemically amplified resist on a substrate, exposing the resist to radiation to form a picture image, developing the exposed resist to form a resist pattern, applying a coating agent containing a water soluble resin such as polyvinyl acetal, a water soluble crosslinking agent such as tetra(hydroxymethyl)glycoluril, a water-soluble nitrogen-containing organic compound such as an amine, and optionally a fluorine- or silicon-containing surfactant onto the resist pattern, and treating the resulting material with heat to form a water-insoluble reactive layer in the interface of the resist pattern and the film for resist pattern micronization, and washing with pure water to remove the unreacted region on the film for resist pattern micronization (Patent Document 4).

These methods are preferable for simply micropatterning using a micropattern formation material (upper layer resist) exceeding the wavelength limit of a photosensitive resist (lower layer resist). However, the method is not still satisfactory due to several problems. For example, the micropattern forming material may crosslink even in unnecessary parts on the bottom of the resist pattern, the resulting resist pattern may have a skirt-like form, the micropattern forming material may have a crosssection form with improper verticality, and the pattern shape may be affected by a mixing bake operation which is conducted in order to cause the upper layer resist pattern size to crosslink. In addition, since the these processes have high thermal dependency of several tens of nm/°C, it is difficult to uniformly maintain the temperature in the wafer plane when increasing the size of the substrate or decreasing the size of the patterns. Therefore, the processes have a problem of poor capability of controlling the resulting pattern size. Furthermore, the above micropattern forming material using a water soluble resin has a problem of poor resistance to dryetching due to limitation of water solubility. When preparing a semiconductor device, the resist pattern is transferred onto a substrate by dryetching using a mask. When the micropattern forming material has poor dryetching resistance, the resist pattern cannot be precisely transferred onto the substrate.

In addition to the above methods, a thermo-flow process has been proposed. The process comprises forming a photoresist pattern on a substrate and fluidizing the photoresist pattern by applying heat or radiation to reduce the pattern size to a level less than the resolution limit (Patent Document 5 and Patent Document 6). However, this process could not produce products with a constant product quality because of difficulty in controlling the fluidity of the resist using heat or radiation.

An improvement of the thermo-flow process has been proposed. According to the proposed process, the fluidity of the photoresist is controlled by providing a water soluble resin film after forming a photoresist pattern on a substrate (Patent Document 7). However, this process has a drawback of leaving a residue of the water soluble resin, since the water soluble resin such as polyvinyl alcohol used in this process does not always have the solubility and stability over time required for being removed by water.

Furthermore, a coating agent for micronizing resist patterns and a method for efficiently forming micronized resist patterns using this coating agent have been proposed. According to the method, when a micronized resist pattern formed by using a photoresist is shrunken with heat, a resist pattern upper coating material which can be removed by water is provided to thermally shrink the resist pattern (Patent Document 8). However, the agent for forming a resist pattern upper coating for micronization used in this method is an aqueous material and cannot adequately cover a micropattern such as a contact hole with a diameter of 100 nm or less. In addition, a cup for exclusive use with such an aqueous agent is required, leading to a cost increase. Another problem with this method is frost and deposition when cooled during transportation.

The inventors of the present invention have previously proposed a resin composition for forming a micropattern comprising a hydroxyl group-containing resin, a crosslinking component, and an alcohol solvent which contains not more than 10 mass% water relative to the total solvent (Patent Document 9).

Patent Document 1: Japanese Patent No. 2723260
Patent Document 2: JP-A-6-250379
Patent Document 3: JP-A-10-73927
Patent Document 4: JP-A-2001-19860
Patent Document 5: JP-A-1-307228
Patent Document 6: JP-A-4-364021
Patent Document 7: JP-A-7-45510
Patent Document 8: JP-A-2003-195527
Patent Document 9: WO 05/116776

### DISCLOSURE OF THE INVENTION

The resin composition for forming a micropattern disclosed in Patent Document 9 is a resin composition used when shrinking a pattern by heat treatment after patterning. Since an alcohol solvent is used instead of water, the composition exhibits excellent applicability to a fine resist pattern and an excellent capability of controlling the dimensions of a cured film. Therefore, the resin composition can effectually and precisely micronize the resist pattern gaps irrespective of the surface conditions of the substrate and can form resist patterns exceeding the wavelength limit economically at low cost in a good condition having only small defects. However, a further improvement in pattern shrink rate has been desired for resist patterning in recent years. Therefore, development of a means for increasing the pattern shrink rate in a more stable manner has been desired.

The present invention has been achieved in view of such a situation, and has an object of providing a resin composition which can increase the pattern shrink rate while maintaining the advantages of the resin composition described in Patent Document 9, that is, the capability of effectually and precisely micronizing the resist pattern gaps irrespective of the surface conditions of the substrate and forming resist patterns exceeding the wavelength limit economically at low cost in a good condition having only small defects, and a method of efficiently forming a micropattern using the resin composition.

The inventors of the present invention have extensively investigated the resin composition such as the composition described in Patent Document 9 and other documents. As a result, the inventors have found that the pattern shrink rate can be further increased by using a compound containing two or more acryloyloxy groups in the molecule as a crosslinking component. This finding has led to the completion of the present invention. Specifically, the following resin compositions for forming a micropattern and methods of forming a micropattern are provided according to the present invention.

[1] A resin composition for forming a micropattern comprising a hydroxyl group-containing resin, a crosslinking component, and an alcohol solvent, the crosslinking component comprising a compound having a structure shown by the following formula (1) in the molecule,

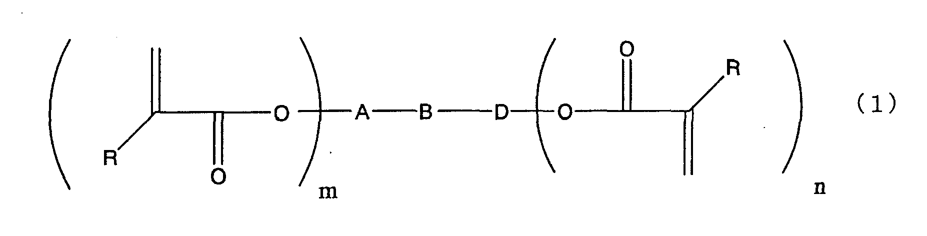

wherein A and D represent a substituted or unsubstituted methylene group or an alkylene group having 2 to 10 carbon atoms, B represents a single bond, an ester, or -O-, R individually represents a hydrogen atom or a methyl group, m and n represent integers from 1 to 5, provided that m+n = 2 to 8, and, when A or D has one carbon atom, m or n is 1 to 3.

[2] The resin composition for forming a micropattern according to [1], wherein the alcohol solvent is a monohydric alcohol having 1 to 8 carbon atoms.

[3] The resin composition for forming a micropattern according to [2], wherein the alcohol solvent contains not more than 10 mass% of water relative to the total solvent.

[4] The resin composition for forming a micropattern according to any one of [1] to [3], wherein the crosslinking component further comprises at least one compound selected from a compound containing a group shown by the following formula (2) and a compound containing two or more cyclic ethers as reactive groups,

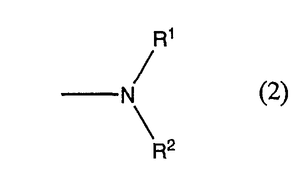

wherein R¹ and R² represent a hydrogen atom or a group shown by the following formula (3), provided that at least one of R¹ and R² is a group shown by the following formula (3),

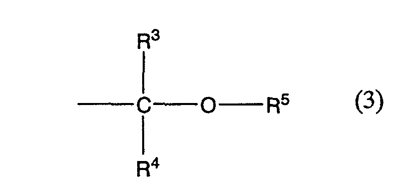

wherein R³ and R⁴ individually represent a hydrogen atom, an alkyl group having 1 to 6 carbon atoms, or an alkoxyalkyl group having 1 to 6 carbon atoms, or R³ and R⁴ bond together to form a ring having 2 to 10 carbon atoms, and R⁵ represents a hydrogen atom or an alkyl group having 1 to 6 carbon atoms.

[5] A method of forming a micropattern comprising a resist pattern forming step of forming a resist pattern on a substrate, an application step of applying a resin composition for forming a micropattern to the resist pattern, a heat treatment step of heat-treating the substrate subjected to the application step, and a washing step of washing the substrate with an alkaline aqueous solution and water, the resin composition being the resin composition according to any one of [1] to [4].

The resin composition for forming a micropattern of the present invention can effectually and precisely micronize the resist pattern gaps irrespective of the surface conditions of the substrate and can form resist patterns exceeding the wavelength limit economically at low cost in a good condition having only small pattern defects. In addition, the resin composition can promote the pattern shrink rate.

### BEST MODE FOR CARRYING OUT THE INVENTION

### [1] Resin composition for forming micropattern:

The resin composition for forming a micropattern of the present invention is an alcohol solution containing a hydroxyl group-containing resin, a crosslinking component, and an alcohol solvent. The crosslinking component includes a compound having two or more acryloyloxy groups in the molecule. The crosslinking component may further include a compound having a group shown by the formula (2).

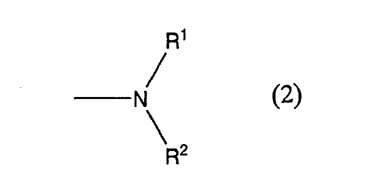

wherein R¹ and R² represent a hydrogen atom or a group shown by the following formula (3), provided that at least one of R¹ and R² is a group shown by the following formula (3),

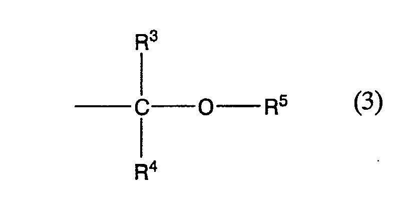

wherein R³ and R⁴ represent a hydrogen atom, an alkyl group having 1 to 6 carbon atoms, or an alkoxyalkyl group having 1 to 6 carbon atoms, or R³ and R⁴ bond together to form a ring having 2 to 10 carbon atoms, and R⁵ represents a hydrogen atom or an alkyl group having 1 to 6 carbon atoms.

### [1-1] Hydroxyl group-containing resin:

The hydroxyl group-containing resin may be any resin containing a structural unit which has at least one hydroxyl group (-OH) selected from hydroxyl groups derived from an alcohol, a phenol, and a carboxylic acid. As such a resin, a (meth)acrylic resin, a vinyl resin (the (meth)acrylic resin and vinyl resin are hereinafter referred to as "Copolymer I"), a novolak resin, or a mixture of these resins can be used. The resin composition for forming a micropattern exhibiting excellent etching resistance can be obtained by using the alcohol-soluble hydroxyl group-containing resin.

Copolymer I can be obtained by copolymerizing monomers having at least one hydroxyl group selected from an alcoholic hydroxyl group, a hydroxyl group derived from a carboxylic acid, and a phenolic hydroxyl group.

As examples of the monomer containing an alcoholic hydroxyl group, hydroxyalkyl (meth)acrylates such as 2-hydroxyethyl acrylate, 2-hydroxyethyl methacrylate, 2-hydroxypropyl acrylate, 2-hydroxypropyl methacrylate, 4-hydroxybutyl acrylate, 4-hydroxybutyl methacrylate, glycerol monomethacrylate, and the like can be given. Of these, preferable monomers are 2-hydroxyethyl acrylate and 2-hydroxyethyl methacrylate. These monomers may be used either individually or in combination of two or more.

A hydroxyl group-containing monomer having a fluoroalkyl group at the α-position shown by the following formula (4) can also be used.

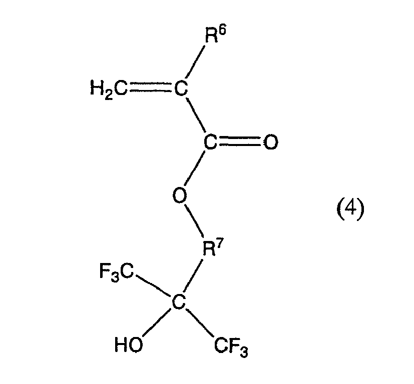

wherein R⁶ represents a hydrogen atom or a methyl group and R⁷ represents a linear or cyclic divalent hydrocarbon group.

As examples of R⁷, saturated chain hydrocarbon groups such as a methylene group, an ethylene group, a propylene group (1,3-propylene group, 1,2- propylene group), a tetramethylene group, a pentamethylene group, a hexamethylene group, a heptamethylene group, an octamethylene group, a nonamethylene group, a decamethylene group, an undecamethylene group, a dodecamethylene group, a tridecamethylene group, a tetradecamethylene group, a pentadecamethylene group, a hexadecamethylene group, a heptadecamethylene group, an octadecamethylene group, a nonadecamethylene group, an icosylene group, a 1-methyl-1,3-propylene group, a 2-methyl-1,3-propylene group, a 2-methyl-1,2-propylene group, a 1-methyl-1,4-butylene group, a 2-methyl-1,4-butylene group, an ethylidene group, a propylidene group, and a 2-propylidene group; monocyclic hydrocarbon groups such as cycloalkylene groups having 3 to 10 carbon atoms such as cyclobutylene groups (e.g., a 1,3-cyclobutylene group), cyclopentylene groups (e.g., a 1,3-cyclopentylene group), cyclohexylene groups (e.g., a 1,4-cyclohexylene group), and cyclooctylene groups (e.g., a 1,5-cyclooctylene group); bridged cyclic hydrocarbon groups such as cyclic hydrocarbon groups with 2 to 4 rings having 4 to 30 carbon atoms such as norbornylene groups (e.g., 1,4-norbornylene group, 2,5-norbornylene group), and admantylene groups (e.g., 1,5-admantylene group, 2,6-admantylene group); and the like can be given.

When R⁷ is an alicyclic hydrocarbon group, it is particularly preferable to insert an alkylene group having 1 to 4 carbon atoms as a spacer between a bistrifluoromethyl hydroxymethyl group and R⁷. Of the above, groups having a 2,5-norbornylene group or a 1,2-propylene group as R⁷ are preferable as the groups of formula (4). As a preferable monomer represented by the formula (4), 4,4,4-trifluoro-3-hydroxy-1-methyl-3-trifluoromethyl-1-butyl methacrylate can be given. The proportion of these monomers in the total monomers forming the copolymer is usually 5 to 90 mol%, and preferably 10 to 60 mol%.

As examples of the monomers containing a hydroxyl group derived from an organic acid such as a carboxylic acid, monocarboxylic acids such as acrylic acid, methacrylic acid, crotonic acid, 2-succinoloylethyl (meth)acrylate, 2-maleinoloylethyl (meth)acrylate, 2-hexahydrophthaloylethyl (meth)acrylate, ω-carboxypolycaprolactone monoacrylate, phthalic acid monohydroxyethyl acrylate, acrylic acid dimer, 2-hydroxy-3-phenoxypropyl acrylate, t-butoxy methacrylate, and t-butyl acrylate; (meth)acrylic acid derivatives having a carboxyl group such as dicarboxylic acids such as maleic acid, fumaric acid, citraconic acid, mesaconic acid, or itaconic acid; and the like can be given. These compounds may be used either individually or in combination of two or more. As examples of commercially available products of ω-carboxypolycaprolactone monoacrylate, acrylic dimmer, and 2-hydroxy-3-phenoxypropyl acrylate, "Aronix M-5300", "Aronix M-5600", and "Aronix M-5700", all manufactured by Toagosei Co., Ltd. can be respectively given.

Of these, acrylic acid, methacrylic acid, and 2-hexahydrophthaloylethyl methacrylate are preferable. The proportion of these monomers in the total monomers forming the copolymer is usually 5 to 90 mol%, and preferably 10 to 60 mol%.

As examples of the monomer containing a phenolic hydroxyl group, p-hydroxystyrene, m-hydroxystyrene, o-hydroxystyrene, α-methyl-p-hydroxystyrene, α-methyl-m-hydroxystyrene, α-methyl-o-hydroxystyrene, 2-allylphenol, 4-allylphenol, 2-allyl-6-methylphenol, 2-allyl-6-methoxyphenol, 4-allyl-2-methoxyphenol, 4-allyl-2,6-dimethoxyphenol, 4-allyloxy-2-hydroxybenzophenone, and the like can be given. Of these, p-hydroxystyrene or α-methyl-p-hydroxystyrene is preferable.

As a monomer having a phenolic hydroxyl group, a monomer having an amide group in the molecule shown by the following formula (5) can be given.

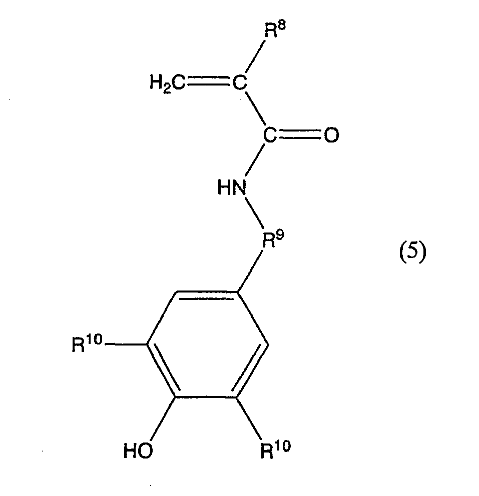

wherein R⁸ and R¹⁰ individually represent a hydrogen atom or a methyl group and R⁹ is the same as R⁷ of the formula (4). As the monomer shown by the formula (5), p-hydroxymethacrylanilide is preferable. The proportion of the monomers having a phenolic hydroxyl group shown by the formula (5) in the total monomers forming the copolymer is usually 30 to 95 mol%, and preferably 40 to 90 mol%.

A monomer having a functional group convertible into a phenolic hydroxyl group after copolymerization can also be copolymerized. As examples of such a monomer, p-acetoxystyrene, α-methyl-p-acetoxystyrene, p-benzyloxystyrene, p-tert-butoxystyrene, p-tert-butoxycarbonyloxystyrene, p-tert-butyldimethylsiloxystyrene, and the like can be given. When the compounds having these functional groups are used, the functional group can be easily converted into a phenolic hydroxyl group by an appropriate treatment, for example, hydrolysis using hydrochloric acid or the like. The proportion of the monomers having the functional group before and after conversion into the phenolic hydroxyl group in the total monomers forming the copolymer is usually 5 to 90 mol%, and preferably 10 to 80 mol%.

The proportions of the monomers having an alcoholic hydroxyl group, a hydroxyl group derived from carboxylic acid, or a phenolic hydroxyl group in the total monomers forming the copolymer I are respectively in the above-described ranges. If the amount of the structural unit having a hydroxyl group is too small, the number of the sites reactive with the later-described crosslinking component is insufficient for the resist material to cause pattern shrinkage. If the amount is too great, on the other hand, the resist material may swell during development and fill out the patterns.

In the case of the monomer having a phenolic hydroxyl group and the monomer having an alcoholic hydroxyl group, for example, the copolymer may consist only of the structural units having hydroxyl groups.

In producing the copolymer I, other monomers may be copolymerized in order to control hydrophilicity and solubility of the resin. The other monomers herein indicate monomers other than the above-described monomers having at least one hydroxyl group selected from an alcoholic hydroxyl group, a hydroxyl group derived from an organic acid such as a carboxylic acid, and a phenolic hydroxyl group. As examples of such other monomers, (meth)acrylic acid aryl esters, dicarboxylic acid diesters, nitrile group-containing polymerizable compounds, amide bond-containing polymerizable compounds, vinyl compounds, allyl compounds, chlorine-containing polymerizable compounds, conjugated diolefins, and the like can be given.

Specific examples include dicarboxylic acid diesters such as diethyl maleate, diethyl fumarate, and diethyl itaconate; (meth)acrylic acid aryl esters such as phenyl (meth)acrylate and benzyl (meth)acrylate; aromatic vinyl compounds such as styrene, α-methylstyrene, m-methylstyrene, p-methylstyrene, vinyltoluene, p-methoxystyrene, and p-t-butoxystyrene; (meth)acrylates such as t-butyl (meth)acrylate and 4,4,4-trifluoro-3-hydroxy-1-methyl-3-trifluoromethyl-1-butyl (meth)acrylate; nitrile group-containing polymerizable compounds such as acrylonitrile and methacrylonitrile; amide bond-containing polymerizable compounds such as acrylamide and methacrylamide; fatty-acid vinyl compounds such as vinyl acetate; chlorine-containing polymerizable compounds such as vinyl chloride and vinylidene chloride; conjugated diolefins such as 1,3-butadiene, isoprene, and 1,4-dimethylbutadiene; and the like. These compounds may be used either individually or in combination of two or more.

The copolymer I is prepared by, for example, polymerizing a mixture of the monomers in an appropriate solvent in the presence of a chain transfer agent, as required, using a radical polymerization initiator such as a hydroperoxide, a dialkyl peroxide, a diacyl peroxide, or an azo compound.

As examples of the solvent which can be used for the polymerization, alkanes such as n-pentane, n-hexane, n-heptane, n-octane, n-nonane, and n-decane; cycloalkanes such as cyclohexane, cycloheptane, cyclooctane, decalin, and norbornane; aromatic hydrocarbons such as benzene, toluene, xylene, ethylbenzene, and cumene; halogenated hydrocarbons such as chlorobutanes, bromohexanes, dichloroethanes, hexamethylene dibromide, and chlorobenzene; saturated carboxylic acid esters such as ethyl acetate, n-butyl acetate, i-butyl acetate, methyl propionate, and propylene glycol monomethyl ether acetate; alkyllactones such as γ-butyrolactone; ethers such as tetrahydrofuran, dimethoxyethanes, and diethoxyethanes; alkylketones such as 2-butanone, 2-heptanone, and methyl isobutyl ketone; cycloalkylketones such as cyclohexanone; alcohols such as 2-propanol, 1-butanol, 4-methyl-2-pentanol, and propylene glycol monomethyl ether; and the like can be given. These solvents may be used either individually or in combination of two or more.

The polymerization temperature is usually from 40 to 120°C, and preferably from 50 to 100°C. The reaction time is usually from 1 to 48 hours, and preferably from 1 to 24 hours.

It is preferable that the copolymer I have a high purity. Not only is the content of impurities such as halogens or metals preferably small, but also the content of residual monomers and oligomers is preferably less than the prescribed amount, for example, the content determined by HPLC is preferably 0.1 mass% or less. The copolymer I with a high purity ensures further improvement of process stability, pattern profile, and the like of the resin composition for forming a micropattern of the present invention containing copolymer I and provides a resin composition for forming a micropattern of which the content of foreign matter in a solution and the sensitivity do not change over time.

As examples of the purification method of the copolymer I obtained in the above method, the following methods can be given. As a method for removing impurities such as metals, a method of causing metals in the polymer solution to be adsorbed using a zeta-potential filter, a method of causing metals to be in a chelate state by washing the polymer solution with an acidic aqueous solution such as oxalic acid or sulfonic acid aqueous solution and removing the metals, and the like can be given. As a method for removing the residual monomers and oligomer components to reduce their content to a concentration not more than a specific value, a liquid-liquid extraction method in which the residual monomers and oligomer components are removed by washing with water or a combination of suitable solvents, a purification method in a solution state such as ultrafiltration in which only the monomers and oligomer components having a specific molecular weight or less are extracted and removed, a reprecipitation method in which the residual monomers and the like are removed by adding the polymer solution to a poor solvent dropwise, thereby causing the polymer to coagulate in the poor solvent, a purification method in a solid state in which the resin slurry separated by filtration is washed with a poor solvent, and the like can be given. These methods may be used in combination.

The polystyrene-reduced mass average molecular weight Mw of the copolymer I determined by gel permeation chromatography is usually 1000 to 500,000, preferably 1000 to 50,000, and particularly preferably 1000 to 20,000. If the molecular weight is too great, the copolymer may not be removed by a developer after curing with heat; if too small, a uniform film may not be formed after application.

The novolak resin used in the present invention is preferably soluble in alkali. Such a novolak resin can be obtained by, for example, addition condensation of an aromatic compound having a phenolic hydroxyl group (hereinafter referred to as "phenols") and an aldehyde in the presence of an acid catalyst. Examples of the phenols used in the addition condensation include phenol, o-cresol, m-cresol, p-cresol, o-ethylphenol, m-ethylphenol, p-ethylphenol, o-butylphenol, m-butylphenol, p-butylphenol, 2,3-xylenol, 2,4-xylenol, 2,5-xylenol, 2,6-xylenol, 3,4-xylenol, 3,5-xylenol, 2,3,5-trimethylphenol, 3,4,5-trimethylphenol, p-phenylphenol, resorcinol, hydroquinone, hydroquinone monomethyl ether, pyrogallol, fluoroglycinol, hydroxydiphenyl, bisphenol A, gallic acid, gallic acid ester, α-naphthol, β-naphthol, and the like. The aldehydes include, for example, formaldehyde, paraformaldehyde, furfural, benzaldehyde, nitrobenzaldehyde, acetaldehyde, and the like. There are no specific limitations to the catalyst for the addition condensation reaction. For example, hydrochloric acid, nitric acid, sulfuric acid, formic acid, oxalic acid, acetic acid, and the like can be used as the acid catalyst. Although the mass average molecular weight of the novolac resin is not specifically limited, a preferable range is from 1000 to 30,000.

### [1-2] Crosslinking component:

The composition of the present invention comprises a compound having two or more acryloyloxy groups in the molecule (hereinafter referred to as "crosslinking component I") as a crosslinking component. Use of such a compound as the crosslinking component can bring about a preferable effect of increasing the pattern shrink rate.

Although there are no specific limitations to the upper limit of the number of acryloyloxy groups in the molecule, such a number is preferably 2 to 8, and more preferably 2 to 4. When the number of acryloyloxy groups in the molecule is 2 to 8, the pattern shrink rate can be further increased while maintaining the storage stability of the solution. If the number of the acryloyloxy group in the molecule is more than 8, the storage stability of the composition may be decreased depending on the conditions.

Light Acrylate (manufactured by Kyoeisha Chemical Co., Ltd.) can be given as an example of the crosslinking component I.

As specific examples of Light Acrylate (manufactured by Kyoeisha Chemical Co., Ltd.), PE-4A (four acryloyloxy groups, E-1), DPE-6A (six acryloyloxy groups, E-2), and the like can be given. Of these, PE-4A is preferable due to a particularly significant effect of increasing the pattern shrink rate.

The amount of the crosslinking component I to be added is 5 to 200 parts by mass, and preferably 5 to 100 parts by mass for 100 parts by mass of the hydroxyl group-containing resin. If less than 5 parts by mass, there may be a tendency for improvement of the pattern shrink rate to be insufficient. If more than 200 parts by mass, the resulting composition may exhibit inferior storage stability.

In addition to the crosslinking component I, it is preferable that the composition of the present invention comprise a compound containing a group shown by the following formula (2) (hereinafter referred to as "crosslinking component II") as the crosslinking component. This compound is an aminal having a structure -NCO- in the molecule which acts as a crosslinking component (curing component) with which the hydroxyl group-containing resin and/or the crosslinking components mutually react by the action of an acid like crosslinking component I. If the crosslinking component II is used in addition to the crosslinking component I, not only is the pattern shrink rate increased, but also an effect of increasing marginal resolution, which cannot be obtained using only the crosslinking component I, can be provided.

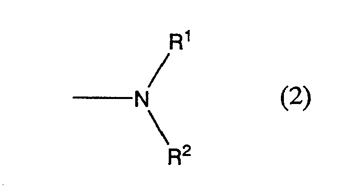

wherein R¹ and R² represent a hydrogen atom or a group shown by the following formula (3), provided that at least one of R¹ and R² is a group shown by the following formula (3),

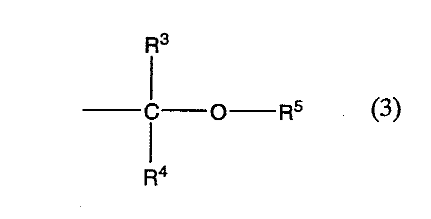

wherein R³ and R⁴ individually represent a hydrogen atom, an alkyl group having 1 to 6 carbon atoms, an alkoxyalkyl group having 1 to 6 carbon atoms, or R³ and R⁴ bond together to form a ring having 2 to 10 carbon atoms, and R⁵ represents a hydrogen atom or an alkyl group having 1 to 6 carbon atoms.

The compound (crosslinking component II) shown by the formula (2) is a compound having an imino group, a methylol group, a methoxymethyl group, or the like as a functional group in the molecule, and includes, for example, nitrogen-containing compounds prepared by alkyl-etherification of all or a part of active methylol groups of a compound such as (poly)methylolized melamine, (poly)methylolized glycoluril, (poly)methylolized benzoguanamine, (poly)methylolized urea, and the like. As examples of the alkyl group, a methyl group, an ethyl group, a butyl group, or a mixture of these groups can be given, and may include an oligomer component which is made by partial condensation. As specific examples, hexamethoxymethylated melamine, hexabutoxymethylated melamine, tetramethoxymethylated glycoluril, tetrabutoxymethylated glycoluril, and the like can be given.

As commercially available compounds, Cymel 300, Cymel 301, Cymel 303, Cymel 350, Cymel 232, Cymel 235, Cymel 236, Cymel 238, Cymel 266, Cymel 267, Cymel 285, Cymel 1123, Cymel 1123-10, Cymel 1170, Cymel 370, Cymel 771, Cymel 272, Cymel 1172, Cymel 325, Cymel 327, Cymel 703, Cymel 712, Cymel 254, Cymel 253, Cymel 212, Cymel 1128, Cymel 701, Cymel 202, and Cymel 207(manufactured by Nihon Cytec Industries, Inc.), Nikalac MW-30M, Nikalac MW-30, Nikalac MW-22, Nikalac MW-24X, Nikalac MS-21, Nikalac MS-11, Nikalac MS-001, Nikalac MX-002, Nikalac MX-730, Nikalac MX-750, Nikalac MX-708, Nikalac MX-706, Nikalac MX-042, Nikalac MX-035, Nikalac MX-45, Nikalac MX-410, Nikalac MX-302, Nikalac MX-202, Nikalac SM-651, Nikalac SM-652, Nikalac SM-653, Nikalac SM-551, Nikalac SM-451, Nikalac SB-401, Nikalac SB-355, Nikalac SB-303, Nikalac SB-301, Nikalac SB-255, Nikalac SB-203, Nikalac SB-201, Nikalac BX-4000, Nikalac BX-37, Nikalac BX-55H, and Nikalac BL-60 (manufactured by Sanwa Chemical Co., Ltd.), and the like can be given. Among these, Cymel 300, Cymel 325, Cymel 327, Cymel 703, Cymel 712, Cymel 254, Cymel 253, Cymel 212, Cymel 1128, Cymel 701, Cymel 202, and Cymel 207 are preferable.

When the crosslinking component I is used alone as the crosslinking component, the amount of the crosslinking component I to be added is preferably 1 to 100 parts by mass, and more preferably 5 to 70 parts by mass for 100 parts by mass of the hydroxyl group-containing resin. If the amount is less than 1 part by mass, the resin composition is cured only inadequately and may not cause pattern shrinkage; if more than 100 parts by mass, there is a possibility that patterns are buried due to excessive curing.

When the crosslinking component I and the crosslinking component II are used in combination as the crosslinking component, the total amount of the crosslinking component I and the crosslinking component II is preferably 1 to 100 parts by mass, and more preferably 5 to 70 parts by mass for 100 parts by mass of the hydroxyl group-containing resin. The ratio of the crosslinking component I and the crosslinking component II is preferably 80:20 to 20:80, and more preferably 70:30 to 30:70. If the ratio of the crosslinking component I to the crosslinking component II is less than 20:80, pattern shrinkage may be insufficient. If the ratio of the crosslinking component II is less than 80:20, marginal resolution may be insufficient.

The total amount of the hydroxyl group-containing resin and the crosslinking component in the resin composition including the later-described alcohol solvent is 0.1 to 30 mass%, and preferably 1 to 20 mass%. If the total amount of the hydroxyl group-containing resin and the crosslinking component is less than 0.1 mass%, the thickness of the film is so small that the film may be cut at etched points of the pattern; if more than 30 mass%, the viscosity is too high for the resin to fill out the micropattern.

### [1-3] Alcohol solvent:

The alcohol solvent used in the present invention contains not more than 10 mass% of water relative to alcohol and the total solvent. Any alcohol solvents that can sufficiently dissolve the hydroxyl group-containing resin and the crosslinking component, but do not cause intermixing with the photoresist film when applied onto the photoresist film can be used in the present invention.

A monohydric alcohol having 1 to 8 carbon atoms is preferable as the alcohol. As examples of such a solvent, 1-propanol, isopropanol, 1-butanol, 2-butanol, tert-butanol, 1-pentanol, 2-pentanol, 3-pentanol, 2-methyl-1-butanol, 3-methyl-1-butanol, 3-methyl-2-butanol, 1-hexanol, 2-hexanol, 3-hexanol, 2-methyl-1-pentanol, 2-methyl-2-pentanol, 2-methyl-3-pentanol, 3-methyl-1-pentanol, 3-methyl-2-pentanol, 3-methyl-3-pentanol, 4-methyl-1-pentanol, 4-methyl-2-pentanol, 1-heptanol, 2-heptanol, 2-methyl-2-heptanol, 2-methyl-3-heptanol, and the like can be given. Of these, 1-butanol, 2-butanol, and 4-methyl-2-pentanol are preferable. These alcohols may be used either individually or in combination of two or more.

The alcohol solvents may contain water in an amount of not more than 10 mass%, and preferably not more than 1 mass% relative to the total solvent. If the amount of water is more than 10 mass%, solubility of the hydroxyl group-containing resin decreases. The "alcohol solvent containing not more than 10 mass% of water" includes an alcohol not containing any water. That is, absolute alcohol which does not contain any water is also preferably used as the "alcohol solvent" in the present invention. The term "total solvent" used in the present invention includes the later-described "other solvents", in addition to alcohol and water.

When applying the resin composition for forming a micropattern of the present invention to a photoresist film, other solvents may be mixed in order to adjust applicability. The other solvents allow the resin composition for forming a micropattern to be evenly applied to the photoresist film without eroding the photoresist film.

Examples of the other solvents include cyclic ethers such as tetrahydrofuran and dioxane; alkyl ethers of polyhydric alcohol such as ethylene glycol monomethyl ether, ethylene glycol monoethyl ether, ethylene glycol dimethyl ether, ethylene glycol diethyl ether, diethylene glycol monomethyl ether, diethylene glycol monoethyl ether, diethylene glycol dimethyl ether, diethylene glycol diethyl ether, diethylene glycol ethyl methyl ether, propylene glycol monomethyl ether, and propylene glycol monoethyl ether; alkyl ether acetates of polyhydric alcohol such as ethylene glycol ethyl ether acetate, diethylene glycol ethyl ether acetate, propylene glycol ethyl ether acetate, and propylene glycol monomethyl ether acetate; aromatic hydrocarbons such as toluene and xylene; ketones such as acetone, methyl ethyl ketone, methyl isobutyl ketone, cyclohexanone, 4-hydroxy-4-methyl-2-pentanone, and diacetone alcohol; and esters such as ethyl acetate, butyl acetate, ethyl 2-hydroxypropionate, ethyl 2-hydroxy-2-methylpropionate, ethyl 2-hydroxy-2-methylpropionate, ethyl ethoxyacetate, ethyl hydroxyacetate, methyl 2-hydroxy-3-methylbutanoate, methyl 3-methoxypropionate, ethyl 3-methoxypropionate, ethyl 3-ethoxypropionate, methyl 3-ethoxypropionate, ethyl acetate, and butyl acetate. Among these, cyclic ethers, alkyl ethers of polyhydric alcohol, alkyl ether acetates of polyhydric alcohol, ketones, and esters are preferable.

The amount of the other solvents is not more than 30 mass%, and preferably not more than 20 mass% of the total solvent. If more than 30 mass%, the solvent causes problems such as erosion of a photoresist film, intermixing with the resin composition for forming a micropattern, and the like. As a result, the resin composition may fill out the resist patterns.

### [1-4] Other additives

A surfactant may be added to the resin composition for forming a micropattern of the present invention in order to increase applicability, defoamability, leveling properties, and the like.

As the surfactant, commercially available fluorine-containing surfactants such as BM-1000 and BM-1100 (manufactured by BM Chemie), Megafac F142D, F172, F173, and F183 (manufactured by Dainippon Ink and Chemicals, Inc.), Fluorad FC-135, FC-170C, FC-430, and FC-431 (manufactured by Sumitomo 3M, Ltd.), Surflon S-112, S-113, S-131, S-141, and S-145 (manufactured by Asahi Glass Co., Ltd.), SH-28PA, SH-190, SH-193, SZ-6032, and SF-8428 (manufactured by Toray-Dow Corning Silicone Co., Ltd.), and the like can be given. The amount of these surfactants to be added is preferably not more than 5 parts by mass for 100 parts by mass of the hydroxyl group-containing resin.

### [3] Micropattern forming method

A micropattern can be formed by the following method using the above-mentioned resin composition for forming a micropattern.

### [2-1] Resist pattern forming step:

First, a resist pattern is formed on a substrate. For example, a reflection preventing film (organic film or inorganic film) is formed on an 8 or 12 inch silicon wafer substrate by a generally known method such as spin coating. Next, a photoresist is applied by a generally known method such as spin coating and prebaked (PB) at a temperature of about 80 to 140°C for about 60 to 120 seconds, for example. Then, the resist film is exposed to radiation such as ultraviolet rays (e.g., g-line, i-line, etc.), a KrF excimer laser, an ArF excimer laser, X-rays, electron beams, or the like and subjected to post exposure baking (PEB) at about 80 to 140°C, for example, and developed to form a resist pattern.

### [2-2] Application step:

Next, a film of the resin composition for forming a micropattern is formed on the resist pattern. For example, the above resin composition for forming a micropattern is applied to the substrate on which the above resist pattern is formed by spin coating or the like. In certain cases, the solvent may vaporize and form a film only by spin coating. As required, the film is prebaked (PB) at a temperature of about 80 to 110°C for about 60 to 120 seconds, for example, to form a film of the resin composition for forming a micropattern.

### [2-3] Heat treatment step:

The substrate on which the film has been formed is treated with heat. An acid produced from the photoresist diffuses from the interface with the photoresist into the layers of the resin composition for forming a micropattern by the heat treatment and causes a crosslinking reaction with the resin composition to occur. The state of the crosslinking reaction from the interface of the photoresist is determined by the material of the resin composition for forming a micropattern, the type of the photoresist used, and the baking temperature and time. The temperature and time of the heat treatment are usually about 90 to 160°C for about 60 to 120 seconds.

### [2-4] Washing step:

Finally, the substrate is washed with an alkaline aqueous solution and water. Specifically, the film of the resin composition for forming a micropattern is developed using an aqueous alkaline solution such as tetramethylammonium hydroxide (TMAH) or the like (for example, for about 60 to 120 seconds) to dissolve and remove the film of the non-crosslinked resin composition for forming a micropattern. Lastly, the substrate is washed with water, whereby hole patterns, ellipse patterns, trench patterns, and the like can be miniaturized.

### EXAMPLES

The present invention is described below in more detail by way of examples. However, the present invention is not limited to the following examples.

### [Synthesis Example: Synthesis of hydroxyl group-containing resin]

100 g of p-t-butoxystyrene, 10 g of styrene, and 9.0 g of azobisisobutyronitrile were dissolved in propylene glycol monomethyl ether and reacted at 80°C for 9 hours to polymerize the monomers. The polymerization product was purified by precipitation from methanol to obtain 100 g of a copolymer of p-t-butoxystyrene and styrene with an Mw of 7,300 and Mw/Mn of 1.80. The copolymer and 50 g of 10 mass% sulfuric acid aqueous solution were dissolved in 300 g of propylene glycol monomethyl ether and hydrolyzed at 90°C for six hours. The reaction product was purified by precipitation in a large amount of water until the product was neutralized to obtain 65 g of a copolymer of p-hydroxystyrene and styrene (85:15 mol%) with an Mw of 5,500 and Mw/Mn of 1.55. This copolymer is indicated as a resin P-1.

Mw and Mn of the resin P-1 and other polymers obtained in the following Examples and Synthesis Examples were measured by gel permeation chromatography (GPC) using GPC columns (manufactured by Tosoh Corp., G2000H_{XL} × 2, G3000H_{XL} × 1, G4000H_{XL} × 1) under the following conditions. Flow rate: 1.0 ml/minute, eluate: tetrahydrofuran, column temperature: 40°C, and standard reference material: monodispersed polystyrene

[Synthesis Example 1]

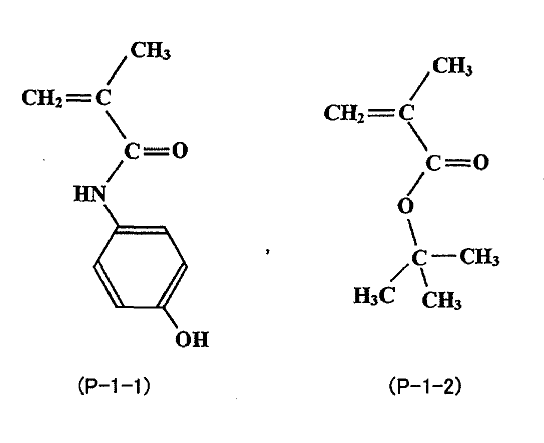

90 g of p-hydroxyphenylmethacrylanilide (P-1-1), 30 g of t-butyl methacrylate (P-1-2), 9 g of azobisisobutyronitrile, and 5 g of 2,4-diphenyl-4-methyl-1-pentene were dissolved in methanol and reacted under refluxing conditions (63°C) for 8 hours to polymerize monomers. The polymerization product was purified by precipitation from a mixture of methanol and water and a mixture of isopropyl alcohol and heptane to obtain 120 g of a polymer of p-hydroxyphenylmethacrylanilide and t-butyl methacrylate (molar ratio: 70:30) with an Mw of 8,500 and Mw/Mn of 2.08. This polymer is indicated as a resin P-2.

[Synthesis Example 2]

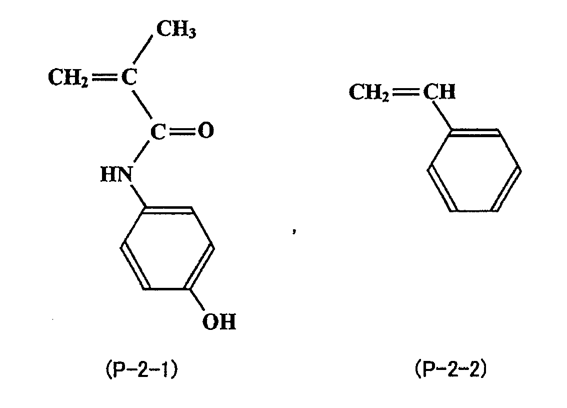

Polymerization was carried out in the same manner as in Example 1, except for using p-hydroxyphenylmethacrylanilide (P-2-1) and styrene (P-2-2) as starting materials to obtain a polymer of p-hydroxyphenylmethacrylanilide and styrene (molar ratio: 70:30) with an Mw of 5,200 and Mw/Mn of 1.62. This polymer is indicated as a resin P-3.

[Synthesis Example 3]

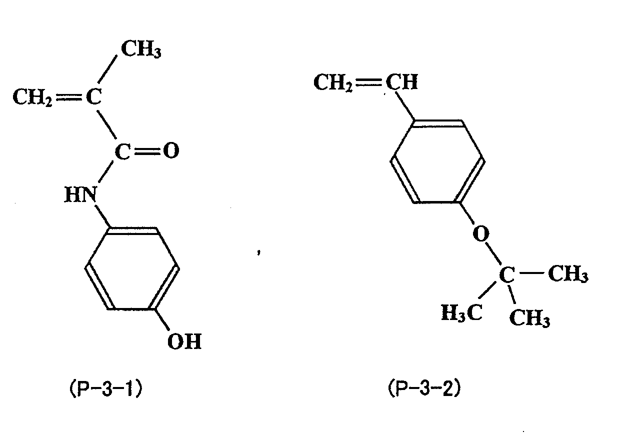

Polymerization was carried out in the same manner as in Example 1, except for using p-hydroxyphenylmethacrylanilide (P-3-1) and p-t-butoxystyrene (P-3-2) as starting materials to obtain a polymer of p-hydroxyphenylmethacrylanilide and p-t-butoxystyrene (molar ratio: 70:30) with an Mw of 7,000 and Mw/Mn of 1.77. This polymer is indicated as a resin P-4.

[Synthesis Example 4]

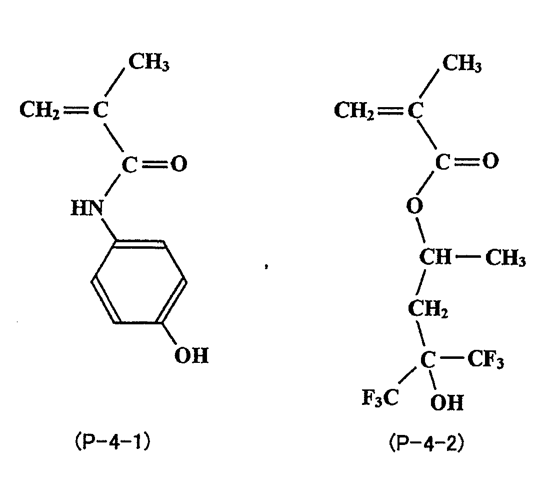

Polymerization was carried out in the same manner as in Example 1, except for using p-hydroxyphenylmethacrylanilide (P-4-1) and 4,4,4-trifluoro-3-hydroxy-1-methyl-3-trifluoromethyl-1-butyl methacrylate (P-4-2) as starting materials to obtain a polymer of p-hydroxyphenylmethacrylanilide and 4,4,4-trifluoro-3-hydroxy-1-methyl-3-trifluoromethyl-1-butyl methacrylate (molar ratio: 85:15) with an Mw of 9,700 and Mw/Mn of 1.99. This polymer is indicated as a resin P-5.

[Synthesis Example 5]

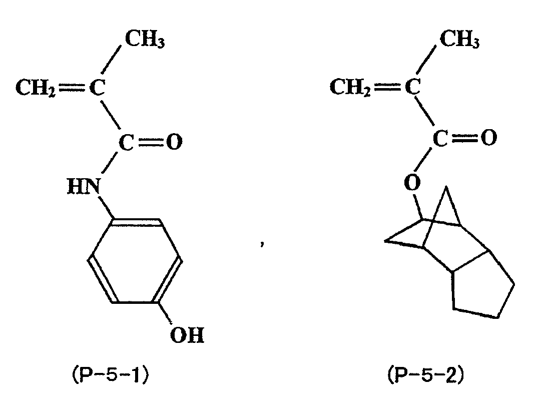

Polymerization was carried out in the same manner as in Example 1, except for using p-hydroxyphenylmethacrylanilide (P-5-1) and 3-tricyclo[4.3.0.1^{2,5}]decane methacrylate (P-5-2) as starting materials to obtain a polymer of p-hydroxyphenylmethacrylanilide and 3-tricyclo[4.3.0.1^{2,5}]decane methacrylate (molar ratio: 70:30) with an Mw of 8,000 and Mw/Mn of 1.80. This polymer is indicated as a resin P-6.

### [Examples 1 to 8 and Comparative Example]

A resin composition for forming a micropattern was obtained by adding a hydroxyl group-containing resin, a crosslinking component, and an alcohol solvent in a proportion shown in Table 1, stirring the mixture for three hours using a stirring blade (at 100 rpm), and filtering the reaction mixture through a filter with a pore diameter of 100 nm. In Table 1, the unit "parts" refers to "part by mass".

The following crosslinking components and alcohol solvents were used in the examples and comparative examples.

### [Compounds containing two or more acryloyloxy group in the molecule)

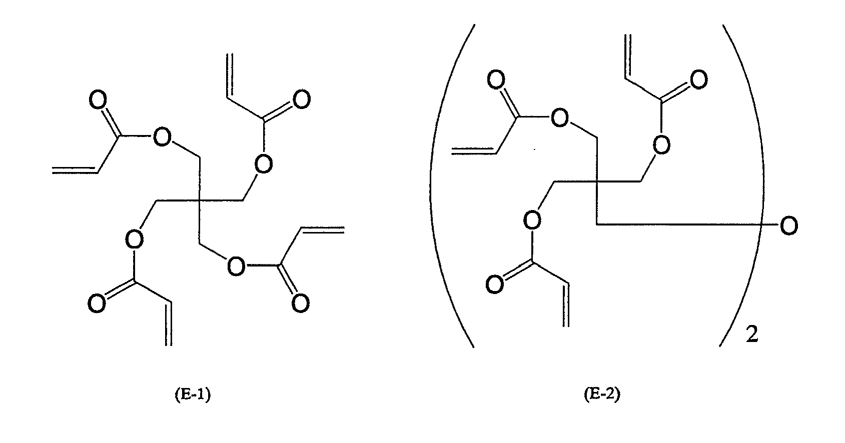

### [Other crosslinking component]

C-1: Cymel 3 00 (trade name, manufactured by Nihon Cytec Industries, Inc.)
C-2: Cymel 325 (trade name, manufactured by Nihon Cytec Industries, Inc.)
C-3: Nikalac MX-750 (trade name, manufactured by Sanwa Chemical Co., Ltd.)

### [Alcohol solvents and other components]

S-1: 1-Butanol
S-2: 4-Methyl-2-pentanol
S-3: 1-Heaxanol
S-4: Water

In order to evaluate the resulting resin composition for forming a micropattern, substrates for evaluation with a resist pattern were prepared by the following methods.

After forming a coating with a thickness of 77 nm (after prebaking at 205°C for 60 seconds) using an underlayer reflection preventing film ARC29A (manufactured by Brewer Science, Inc.) on an 8-inch silicon wafer by spin coating using a Clean Track Act 8 (manufactured by Tokyo Electron, Ltd.), patterns were produced using JSR ArF AR1244J. After coating the AR1244J by spin coating using a Clean Track Act 8 and prebaking (130°C, 90 sec) to produce a film with a thickness of 210 nm, the film was exposed (dose: 30 mJ/cm²) using an ArF projection exposure device S306C (manufactured by Nikon Corp.) under optical conditions ofNA: 0.78, sigma: 0.85, and 2/3Ann, subjected to PEB (130°C, 90 sec) using a Clean Track Act 8 hot plate, subjected to puddle development using an LD nozzle of the Clean Track Act 8 (60 sec), rinsed with ultrapure water, and spin-dried by centrifuging at 4000 rpm for 15 seconds to obtain a substrate for evaluation.

Using the resulting substrates for evaluation, patterns corresponding to a mask pattern with a hole diameter of 100 nm and a space of 100 nm (bias: +30 nm, i.e. hole diameter of 130 nm and space of 70 nm on the mask) were inspected to measure the resist pattern hole diameter using a scanning electron microscope ("S-9360" manufactured by Hitachi High-Tech Fielding Corp.).

The resin compositions for forming a micropattern obtained were evaluated according to the following methods. The evaluation results are shown in Table 1.

### [Evaluation of shrink rate]

A coating with a thickness of 300 nm obtained by applying the resin compositions for forming a micropattern shown in Table 1 to the above-mentioned substrate for evaluation by spin coating using a Clean Track Act 8 and baking (100°C for 90 seconds) was baked at 145°C for 90 seconds to react the resist pattern and the resin composition for forming a micropattern. The substrate was then subjected to paddle development for 60 seconds using a 2.38 mass% of TMAH aqueous solution as a developer jetted from the LD nozzle of the Clean Track Act 8, rinsed with ultrapure water, and spin-dried by centrifuging at 4000 rpm for 15 seconds.

In the Comparative Example 1, the substrate was subjected to paddle development using ultrapure water as a developer jetted from LD nozzles of the Clean Track Act 8 for 60 seconds and spin-dried by centrifuging at 4,000 rpm for 15 seconds.

For the shrink rate evaluation of pattern dimension, patterns corresponding to a mask pattern with a hole diameter of 100 nm and a space of 100 nm (bias: +30 nm, i.e. hole diameter of 130 nm and space of 70 nm on the mask) were inspected to measure the resist pattern hole diameter using a scanning electron microscope ("S-9360" manufactured by Hitachi High-Tech Fielding Corp.). The shrink rate was calculated using the following formula. $Shrink rate \left(%\right) = \left[\left(φ⁢1-φ⁢2/φ⁢1\right)\right] \times 100$
ϕ1: Diameter of resist pattern holes (nm) before shrinking
ϕ2: Diameter of resist pattern holes (nm) after shrinking

A coating was evaluated as "Good" when the shrink rate was 20% or more, and as "Bad" when the shrink rate was less than 20%.

**TABLE 1**

| | Resin | | Acrylic compound (E) | | Other crosslinking component (C) | | Solvent (S) | | Shrink rate | |
|---|---|---|---|---|---|---|---|---|---|---|
| | Type | Parts | Type | Parts | Type | Parts | Type | Parts | (%) | Evaluation |
| Example 1 | P-1 | 100 | E-1 | 30 | C-3 | 30 | S-1 | 1000 | 33.1 | Good |
| | | | | | | | S-4 | 60 | | |
| Example 2 | P-2 | 100 | E-2 | 30 | C-2 | 30 | S-1 | 1000 | 32.7 | Good |
| | | | | | | | S-4 | 60 | | |
| Example 3 | P-3 | 100 | E-1 | 30 | C-1 | 30 | S-1 | 1000 | 31.5 | Good |
| | | | | | | | S-4 | 60 | | |
| Example 4 | P-4 | 100 | E-2 | 30 | C-3 | 30 | S-1 | 1000 | 32.1 | Good |
| | | | | | | | S-4 | 60 | | |
| Example 5 | P-5 | 100 | E-1 | 30 | C-3 | 10 | S-1 | 1000 | 29.5 | Good |
| | | | | | | | S-4 | 60 | | |
| Example 6 | P-6 | 100 | E-2 | 30 | C-3 | 10 | S-1 | 1000 | 28.8 | Good |
| | | | | | | | S-4 | 60 | | |
| Example 7 | P-4 | 100 | E-1 | 30 | C-3 | 40 | S-1 | 1000 | 32.5 | Good |
| | | | | | | | S-4 | 60 | | |
| Example 8 | P-4 | 100 | E-2 | 50 | - | - | S-1 | 1000 | 33.1 | Good |
| | | | | | | | S-4 | 60 | | |
| Example 9 | P-4 | 100 | E-1 | 50 | - | - | S-1 | 1000 | 31.4 | Good |
| Comparative Example | P-1 | 100 | - | - | C-1 | 30 | S-1 | 100 | 9.2 | Bad |

### INDUSTRIAL APPLICABILITY

The resin composition for forming a micropattern of the present invention can effectively and accurately miniaturize resist pattern spaces and can excellently and economically form patterns surpassing a wavelength limit. Therefore, the resin composition can be used very suitably in the field of microfabrication represented by production of integrated circuit elements which are expected to become increasingly micronized in the future.

## Claims

1. A resin composition for forming a micropattern comprising a hydroxyl group-containing resin, a crosslinking component, and an alcohol solvent, the crosslinking component comprising a compound having a structure shown by the following formula (1) in the molecule, 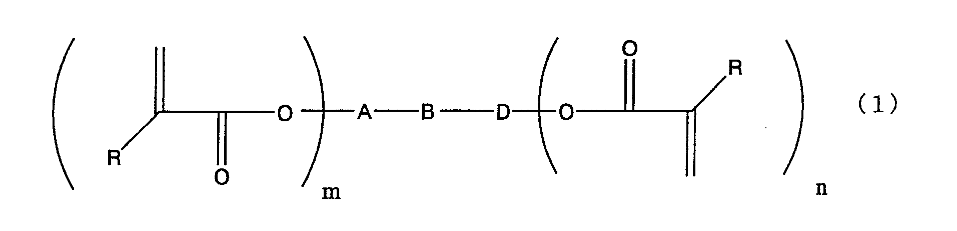 wherein A and D represent a substituted or unsubstituted methylene group or an alkylene group having 2 to 10 carbon atoms, B represents a single bond, an ester, or -O-, R individually represents a hydrogen atom or a methyl group, m and n represent integers from 1 to 5, provided that m+n = 2 to 8, and, when A or D has one carbon atom, m or n is 1 to 3.

2. The resin composition for forming a micropattern according to claim 1, wherein the alcohol solvent is a monohydric alcohol having 1 to 8 carbon atoms.

3. The resin composition for forming a micropattern according to claim 2, wherein the alcohol solvent contains not more than 10 mass% of water relative to the total solvent.

4. The resin composition for forming a micropattern according to any one of claims 1 to 3, wherein the crosslinking component further comprises at least one compound selected from a compound containing a group shown by the following formula (2) and a compound containing two or more cyclic ethers as reactive groups, 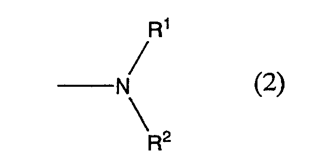 wherein R¹ and R² represent a hydrogen atom or a group shown by the following formula (3), provided that at least one of R¹ and R² is a group shown by the following formula (3), 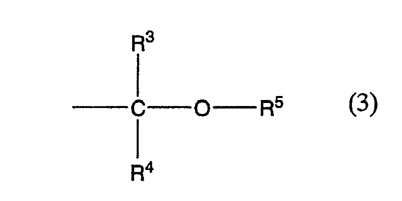 wherein R³ and R⁴ individually represent a hydrogen atom, an alkyl group having 1 to 6 carbon atoms, or an alkoxyalkyl group having 1 to 6 carbon atoms, or R³ and R⁴ bond together to form a ring having 2 to 10 carbon atoms, and R⁵ represents a hydrogen atom or an alkyl group having 1 to 6 carbon atoms.

5. A method of forming a micropattern comprising a resist pattern forming step of forming a resist pattern on a substrate, an application step of applying a resin composition for forming a micropattern to the resist pattern, a heat treatment step of heat-treating the substrate subjected to the application step, and a washing step of washing the substrate with an alkaline aqueous solution and water, the resin composition being the resin composition according to any one of claims 1 to 4.
